# FASCICULE DE BREVET EUROPEEN

(11) **EP 2 993 786 B1**
(45) Date de publication et mention de la délivrance du brevet: **21.09.2016**
(21) Numéro de dépôt: 15183551.9
(22) Date de dépôt: 02.09.2015
(51) Int. Cl.: G11C 14/00

(54) **PORTE C MUNIE D'UNE SAUVEGARDE NON VOLATILE**
MIT EINER NICHT-FLÜCHTIGEN ABSICHERUNG AUSGESTATTETES GATTER C
C-ELEMENT HAVING NON-VOLATILE STORAGE

(30) Priorité: 04.09.2014 FR 1458289
(43) Date de publication de la demande: 09.03.2016
(73) Titulaire: COMMISSARIAT A L'ENERGIE ATOMIQUE ET AUX ENERGIES ALTERNATIVES, 75015 Paris (FR); CENTRE NATIONAL DE LA RECHERCHE SCIENTIFIQUE, 75794 Paris Cedex 16 (FR)
(72) Inventeur: DI PENDINA, Grégory, 38130 ECHIROLLES (FR); BEIGNE, Edith, 38112 MEAUDRE (FR); ZIANBETOV, Eldar, 38130 ECHIROLLES (FR)
(74) Mandataire: Thibon, Laurent

(56) Documents cités:
- WO-A1-01/22591
- WO-A1-2008/001270
- US-A1- 2012 105 102
- US-B1- 6 937 508

## Description

### Domaine

La présente description concerne le domaine des circuits asynchrones, et en particulier une porte C comportant une mémoire non volatile pour la sauvegarde de données.

### Exposé de l'art antérieur

Contrairement aux conceptions à circuits synchrones qui reposent sur un signal d'horloge, les circuits asynchrones ont l'avantage d'être plus ou moins insensibles aux variations de retard résultant par exemple de variations dans le processus de fabrication. En outre, en évitant l'utilisation d'une horloge, les circuits asynchrones ont une consommation d'énergie relativement faible. Les circuits asynchrones sont en général conçus pour fonctionner sur la base d'évènements déterminés en utilisant un protocole de prise de contact spécifique.

Le circuit élémentaire de base d'une conception asynchrone est basé sur un circuit connu sous le nom de porte C ou circuit de Muller. Ce circuit comprend une bascule volatile pour mémoriser un état comme décrit dans le document WO 01/22591 A1 par exemple.

Ainsi, si l'alimentation du circuit asynchrone est coupée, les données mémorisées par les diverses portes C vont être perdues.

Il serait souhaitable d'avoir une porte C ayant une capacité de mémorisation non volatile afin que l'état du circuit puisse être restauré à la suite d'une coupure d'alimentation. Toutefois, il y a des problèmes techniques pour obtenir une solution dans un circuit compact qui ne conduise pas à une augmentation significative de la consommation d'énergie.

### Résumé

Un objet de modes de réalisation de la présente description est de résoudre au moins partiellement un ou plusieurs problèmes de l'art antérieur.

Selon un aspect, on prévoit un circuit comprenant : une porte C comportant des premier et deuxième noeuds d'entrée et des premier et deuxième inverseurs couplés de façon croisée entre des premier et deuxième noeuds de mémorisation complémentaires, le deuxième noeud de mémorisation formant un noeud de sortie de la porte C ; et une mémoire non volatile comprenant : un premier élément résistif ayant une première borne couplée au premier noeud de mémorisation ; un deuxième élément résistif ayant une première borne couplée au deuxième noeud de mémorisation, au moins l'un des premier et deuxième éléments résistifs étant programmable pour prendre l'un d'au moins deux états résistifs, une valeur de données étant représentée par les résistances relatives des premier et deuxième éléments résistifs, une deuxième borne du premier élément résistif étant couplée à une deuxième borne du deuxième élément résistif par l'intermédiaire d'un premier transistor ; et un circuit de commande adapté, pendant une phase de sauvegarde vers la mémoire non volatile d'un bit de données mémorisé au niveau des premier et deuxième noeuds de mémorisation, à rendre conducteur le premier transistor pendant que des niveaux logiques différents sont appliqués aux premier et deuxième noeuds d'entrée de la porte C.

Selon un mode de réalisation, le premier transistor est adapté à conduire un courant d'écriture pendant la phase de sauvegarde, et le circuit est agencé de telle sorte que le courant d'écriture passe à travers au moins un transistor de chacun des premier et deuxième inverseurs pendant la phase d'écriture.

Selon un mode de réalisation, la porte C est adaptée à recevoir un premier signal d'entrée sur le premier noeud d'entrée et un deuxième signal d'entrée sur le deuxième noeud d'entrée ; et le premier inverseur comprend : des premier et deuxième transistors ayant leurs noeuds de commande couplés au premier ou au deuxième noeud de mémorisation ; des troisième et quatrième transistors couplés en parallèle entre eux et couplant le premier transistor du premier inverseur à un rail de tension d'alimentation ; et des cinquième et sixième transistors couplés en parallèle entre eux et couplant le deuxième transistor du premier inverseur au rail de tension de masse.

Selon un mode de réalisation, le deuxième inverseur comprend : des premier et deuxième transistors ayant leurs noeuds de commande couplés au deuxième ou au premier noeud de mémorisation ; et un troisième transistor couplant le premier transistor du deuxième inverseur au rail de tension d'alimentation et ayant son noeud de commande couplé au rail de tension de masse.

Selon un mode de réalisation, les cinquième et sixième transistors du premier inverseur et le deuxième transistor du deuxième inverseur sont couplés à un noeud commun, le circuit comprenant en outre un septième transistor couplé entre le noeud commun et le rail de tension de masse.

Selon un mode de réalisation, le circuit comprend en outre un huitième transistor couplé entre le premier élément résistif et le rail de tension de masse et un neuvième transistor couplé entre le deuxième élément résistif et le rail de tension de masse, le circuit de commande étant en outre adapté à rendre conducteurs les huitième et neuvième transistors pendant une phase de restauration du bit de données mémorisé par les éléments résistifs vers les noeuds de mémorisation.

Selon un mode de réalisation, le huitième transistor est couplé à la deuxième borne du premier élément résistif, et le neuvième transistor est couplé à la deuxième borne du deuxième élément résistif.

Selon un mode de réalisation, au moins l'un des premier et deuxième éléments résistifs est de l'un des types suivants : un élément à couple de transfert de spin ayant une anisotropie dans le plan ; un élément à couple de transfert de spin ayant une anisotropie perpendiculaire au plan ; un élément à oxydoréduction ; un élément ferroélectrique ; et un élément à changement de phase.

Selon un mode de réalisation, les premier et deuxième éléments résistifs comprennent chacun une troisième borne, et le huitième transistor est couplé à la troisième borne du premier élément résistif, et le neuvième transistor est couplé à la troisième borne du deuxième élément résistif.

Selon un mode de réalisation, l'élément résistif est du type à jonction tunnel magnétique à couple spin-orbite.

Selon un autre aspect, on prévoit un circuit intégré comprenant une pluralité de blocs asynchrones comprenant chacun le circuit susmentionné.

Selon un autre aspect, on prévoit un procédé de sauvegarde de données dans un circuit comprenant : une porte C comportant des premier et deuxième noeuds d'entrée et des premier et deuxième inverseurs couplés de façon croisée entre des premier et deuxième noeuds de mémorisation complémentaires, le deuxième noeud de mémorisation formant un noeud de sortie de la porte C ; et une mémoire non volatile comprenant : un premier élément résistif ayant une première borne couplée au premier noeud de mémorisation ; un deuxième élément résistif ayant une première borne couplée au deuxième noeud de mémorisation, au moins l'un des premier et deuxième éléments résistifs étant programmable pour prendre l'un d'au moins deux états résistifs, une valeur de données étant représentée par les résistances relatives des premier et deuxième éléments, une deuxième borne du premier élément résistif étant couplée à une deuxième borne du deuxième élément résistif par l'intermédiaire d'un premier transistor, le procédé comprenant : rendre conducteur le premier transistor pendant que des niveaux logiques différents sont appliqués aux premier et deuxième noeuds d'entrée de la porte C.

### Brève description des dessins

Les avantages susmentionnés, et d'autres, apparaîtront clairement à la lecture de la description détaillée suivante de modes de réalisation, donnés à titre d'illustration et non de limitation, en faisant référence aux dessins joints dans lesquels :
la figure 1 illustre schématiquement un exemple de porte C ;
la figure 2 illustre schématiquement un circuit comprenant une porte C et une mémoire non volatile selon un exemple de réalisation de la présente description ;
la figure 3 est un chronogramme représentant des exemples de signaux dans le circuit de la figure 2 selon un exemple de réalisation ;
la figure 4 illustre un élément résistif du circuit de la figure 2 plus en détail selon un exemple de réalisation ;
la figure 5 illustre un élément résistif du circuit de la figure 2 plus en détail selon un autre exemple de réalisation ;
la figure 6 illustre schématiquement un circuit comprenant une porte C et une mémoire non volatile selon un autre exemple de réalisation de la présente description ; et
la figure 7 illustre un élément résistif du circuit de la figure 6 plus en détail selon un exemple de réalisation.

### Description détaillée

Dans la description qui suit, le terme "connecté" est utilisé pour désigner une connexion directe entre deux éléments, alors que le terme "couplé" est utilisé pour désigner une connexion qui pourrait être directe ou pourrait se faire par l'intermédiaire d'un ou plusieurs éléments intermédiaires comme des résistances, des condensateurs ou des transistors.

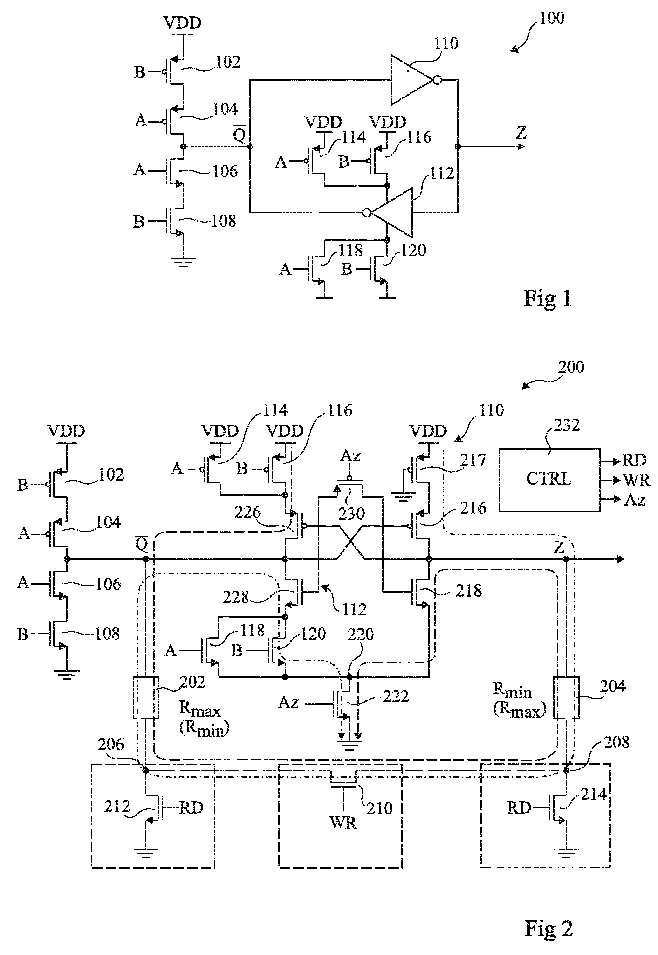

La figure 1 illustre un exemple de porte C 100, connue aussi sous le nom de circuit de Muller. Elle comprend deux noeuds d'entrée de données pour recevoir des signaux d'entrée A et B. Deux transistors 102, 104, qui sont par exemple des transistors PMOS, sont couplés en série entre un rail de tension d'alimentation VDD et un noeud de mémorisation *Q̅* de la porte C. Deux autres transistors 106, 108, qui sont par exemple des transistors NMOS, sont couplés en série entre le noeud de mémorisation *Q̅* et un rail de tension de masse. Les transistors 104 et 106 ont leurs noeuds de commande couplés au noeud d'entrée recevant le signal A et les transistors 102 et 108 ont leurs noeuds de commande couplés au noeud d'entrée recevant le signal B.

Deux inverseurs 110, 112 sont couplés de façon croisée entre le noeud de mémorisation *Q̅* et un autre noeud de mémorisation Z qui constitue le noeud de sortie de la porte C. L'inverseur 112 a par exemple son entrée couplée au noeud de mémorisation Z et sa sortie couplée au noeud de mémorisation *Q̅*, et a ses bornes d'alimentation couplées aux rails de tension d'alimentation par l'intermédiaire d'autres transistors. En particulier, une borne d'alimentation haute de l'inverseur 112 est couplée au rail de tension d'alimentation VDD par l'intermédiaire de chaque transistor d'une paire 114, 116, qui sont par exemple des transistors PMOS couplés en parallèle entre eux. La borne d'alimentation basse de l'inverseur 112 est couplée au rail de tension de masse par l'intermédiaire de chaque transistor d'une paire de transistors 118, 120, qui sont par exemple des transistors NMOS, couplés en parallèle entre eux. Les transistors 114 et 118 ont leurs noeuds de commande couplés au noeud d'entrée destiné à recevoir le signal A, et les transistors 116 et 120 ont leurs noeuds de commande couplés à l'autre noeud d'entrée destiné à recevoir le signal B.

En fonctionnement, la porte C a par exemple un fonctionnement défini par la table de vérité suivante :

| A | B | Z |
|---|---|---|
| 0 | 0 | 0 |
| 0 | 1 | Z⁻¹ |
| 1 | 0 | Z⁻¹ |
| 1 | 1 | 1 |

En d'autres termes, lorsque les valeurs des signaux d'entrée A et B sont au même niveau logique, la sortie Z est mise à ce niveau logique. Lorsque les valeurs des signaux d'entrée A et B sont à des niveaux logiques différents entre eux, le circuit est dans un état d'attente dans lequel la sortie Z reste inchangée, en d'autres termes l'état de tension sur les noeuds de mémorisation ***Q̅*** et Z n'est pas modifié.

La figure 2 illustre un circuit 200 comprenant la porte C 100 de la figure 1, à laquelle a été ajoutée une mémoire non volatile. Les éléments de la porte C 100 ont été référencés avec les mêmes références en figure 2, et ne seront pas de nouveau décrits en détail.

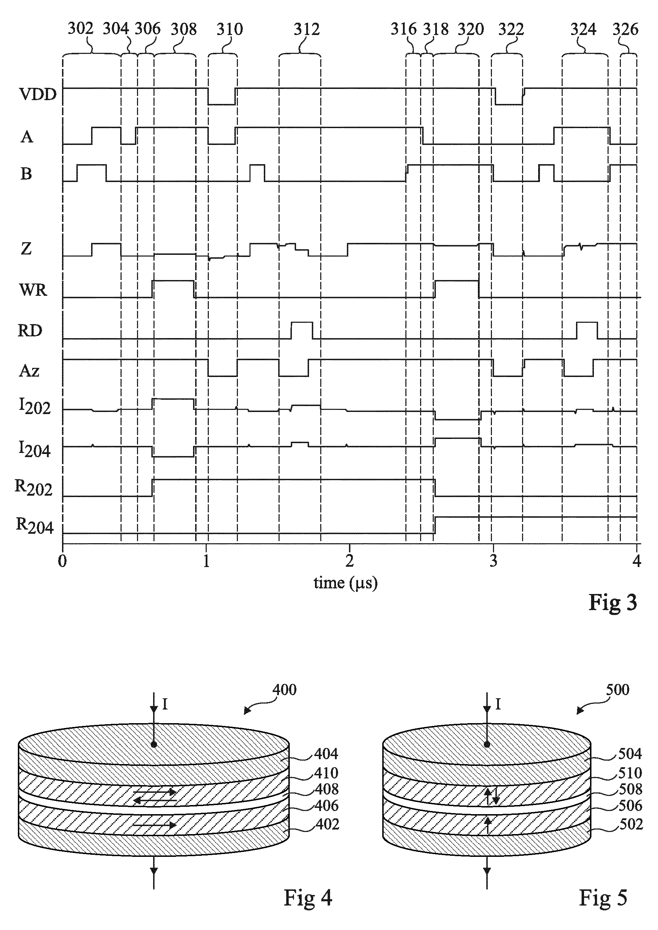

Le circuit 200 de la figure 2 comprend deux éléments résistifs 202, 204, dont chacun peut être programmé pour prendre l'un d'une pluralité d'états résistifs. Les éléments résistifs 202 et 204 peuvent être des éléments à commutation de résistance d'un type quelconque pour lequel la résistance est programmable par le sens d'un courant qu'on fait passer dedans. Par exemple, comme cela va être décrit plus en détail ci-après en référence aux figures 4 et 5, les éléments à commutation de résistance 202, 204 sont des éléments à couple de transfert de spin ayant une anisotropie dans le plan ou perpendiculaire au plan, comme cela est décrit plus en détail dans la publication intitulée "Magnonic spin-transfer torque MRAM with low power, high speed, and error-free switching", N. Mojumder et al., IEDM Tech. Digest (2010), et dans la publication intitulée "Electric toggling of magnets", E. Tsymbal, Natural Materials Vol 11, January 2012. En variante, les éléments résistifs pourraient être ceux utilisés dans des mémoires à commutation résistive dites RAM RedOx (RAM à oxydoréduction), qui sont par exemple décrits plus en détail dans la publication intitulée : "Redox-Based Resistive Switching Memories - Nanoionic Mechanisms, Prospects and Challenges", Rainer Waser et al., Advanced Materials 2009, 21, pages 2632 to 2663. Dans encore un autre exemple, les éléments résistifs pourraient être ceux utilisés dans des FeRAM (RAM ferroélectriques) ou dans des PCRAM (RAM à changement de phase).

Quel que soit le type des éléments résistifs, un bit de données est par exemple mémorisé de façon non volatile en mettant l'un des éléments à une résistance relativement élevée (Rₘₐₓ), et l'autre à une résistance relativement basse (Rₘᵢₙ). Dans l'exemple de la figure 2, l'élément 202 est programmé de façon à avoir une résistance Rₘₐₓ et l'élément 204 une résistance Rₘᵢₙ représentant une valeur du bit de données, et comme cela est représenté par les références Rₘᵢₙ et Rₘₐₓ entre parenthèses, la programmation opposée des valeurs de résistance mémorise la valeur opposée du bit de données. Chacun des éléments à commutation de résistance 202, 204 n'a par exemple que deux états résistifs correspondant aux résistances haute et basse Rₘₐₓ et Rₘᵢₙ, mais les valeurs exactes de Rₘᵢₙ et Rₘₐₓ peuvent varier en fonction de conditions comme le procédé de fabrication, les matériaux, les variations de température, etc.

Le bit de donnée non volatile représenté par les éléments résistifs 202, 204 dépend duquel des éléments résistifs a la résistance Rₘₐₓ ou Rₘᵢₙ, en d'autres termes des résistances relatives. Les éléments résistifs 202, 204 sont par exemple choisis de telle sorte que Rₘₐₓ soit toujours notablement supérieure à Rₘᵢₙ, par exemple, supérieure d'au moins 20 %. En général, le rapport entre la résistance Rₘₐₓ et la résistance Rₘᵢₙ est par exemple compris entre 1,2 et 10 000. Rₘᵢₙ est par exemple de l'ordre de 2 kilo-ohms au moins, et Rₘₐₓ est par exemple de l'ordre de 6 kilo-ohms ou plus, bien que d'autres valeurs soient possibles.

Il sera clair pour l'homme de l'art que dans certains modes de réalisation, au lieu que les éléments résistifs 202, 204 soient programmables tous les deux, un seul soit programmable. Dans un tel cas, l'autre élément résistif a par exemple une résistance fixe au niveau intermédiaire environ à mi-chemin entre Rₘᵢₙ et Rₘₐₓ, par exemple égale, avec une tolérance de 10 %, à (Rₘᵢₙ+(Rₘₐₓ-Rₘᵢₘ)/2) • Par exemple, l'un des éléments résistifs 202, 204 pourrait correspondre à une résistance de valeur fixe. En variante, l'un des éléments résistifs 202, 204 pourrait être constitué d'une paire d'éléments résistifs programmables couplés en parallèle entre eux avec des orientations opposées, de sorte que quel que soit le sens dans lequel chaque élément est programmé, la valeur de résistance reste relativement constante au niveau intermédiaire.

L'élément résistif 202 est couplé entre le noeud de mémorisation ***Q̅*** et un noeud intermédiaire 206. L'élément résistif 204 est couplé entre le noeud de mémorisation Z et un noeud intermédiaire 208. Les noeuds intermédiaires 206 et 208 sont couplés entre eux par l'intermédiaire d'un transistor 210, qui est par exemple un transistor NMOS. Le transistor 210 reçoit sur son noeud de commande un signal d'écriture WR.

Le noeud 206 est en outre couplé au rail de tension de masse par l'intermédiaire d'un transistor 212, qui est par exemple un transistor PMOS. De façon similaire, le noeud 208 est en outre couplé au rail de tension de masse par l'intermédiaire d'un transistor 214, qui est aussi par exemple un transistor NMOS. Les noeuds de commande des transistors 212 et 214 sont contrôlés par un signal de lecture RD.

La figure 2 illustre aussi les inverseurs 110 et 112 plus en détail. L'inverseur 110 comprend par exemple un transistor 216, qui est par exemple un transistor PMOS, couplé entre le noeud de mémorisation Z et le rail de tension d'alimentation VDD. Optionnellement, dans le but d'équilibrer les chemins de lecture pendant une phase de restauration décrite plus en détail ci-après, un autre transistor 217, qui est par exemple un transistor PMOS, est couplé entre le transistor 216 et le rail de tension d'alimentation VDD. L'inverseur 110 comprend aussi par exemple un transistor 218, qui est par exemple un transistor NMOS, couplé entre le noeud de mémorisation Z et un noeud commun 220. Dans certains modes de réalisation, le noeud commun 220 est connecté au rail de tension de masse, tandis que dans des modes de réalisation alternatifs comme cela est représenté en figure 2, le noeud commun 220 est couplé au rail de tension de masse par l'intermédiaire d'un transistor 222, qui est par exemple un transistor NMOS contrôlé par un signal Az décrit en détail ci-après.

L'inverseur 112 comprend par exemple un transistor 226, qui est par exemple un transistor PMOS, couplé entre le noeud de mémorisation ***Q̅*** et la borne de tension haute de l'inverseur 112. L'inverseur 112 comprend aussi par exemple un transistor 228, qui est par exemple un transistor NMOS, couplé entre le noeud de mémorisation ***Q̅*** et la borne de tension d'alimentation de l'inverseur 112. Les transistors 118 et 120 sont couplés entre la borne de tension basse de l'inverseur 112 et le noeud commun 220. Optionnellement, un transistor 230, qui est par exemple un transistor PMOS ayant son noeud de commande couplé de façon à recevoir le signal Az, est couplé entre les noeuds de mémorisation ***Q̅*** et Z.

La figure 2 illustre aussi un bloc de commande 232, fournissant les signaux de commande RD, WR et Az aux transistors correspondants du circuit 200.

Le fonctionnement du circuit 200 de la figure 2 va maintenant être décrit en référence au chronogramme de la figure 3.

La portion de porte C du circuit 200 est par exemple capable d'un fonctionnement normal, non affecté par le circuit non volatile, pendant que les signaux RD et WR restent bas, et le signal Az est haut. Une phase de sauvegarde peut être réalisée périodiquement ou seulement avant une période de coupure d'alimentation, et implique la mémorisation du bit représenté par les états de tension sur les noeuds de mémorisation ***Q̅*** et Z sous la forme d'un état résistif programmé des éléments résistifs 202, 204. Une phase de restauration est par exemple réalisée après la mise sous tension, et implique de mettre les états de tension sur les noeuds de mémorisation ***Q̅*** et Z en fonction des états résistifs programmés des éléments résistifs 202, 204.

La figure 3 illustre des exemples de la tension VDD sur le rail de tension d'alimentation, des signaux A et B, de la tension sur le noeud de mémorisation Z, du signal d'écriture WR, du signal de lecture RD, du signal Az, du courant I₂₀₂ dans l'élément résistif 202, du courant I₂₀₄ dans l'élément résistif 204, de la résistance R₂₀₂ de l'élément résistif 202 correspondant à son état magnétique, et de la résistance R₂₀₄ de l'élément résistif 204 correspondant à son état magnétique.

Une première période 302 en figure 3 correspond à un fonctionnement standard, dans lequel les signaux A et B passent tous les deux d'un état bas à un état haut, et Z passe à l'état haut pendant une période dans laquelle les deux signaux A et B sont hauts et au moins l'un des signaux reste haut.

Dans une période suivante 304, un état zéro est mis sur le noeud de mémorisation Z en amenant les deux signaux A et B à l'état bas.

Des périodes suivantes 306 et 308 correspondent à une phase de sauvegarde pendant laquelle l'état zéro mémorisé par le noeud de mémorisation Z est mémorisé dans les éléments résistifs 202, 204. Cela implique une étape initiale représentée par la période 306 dans laquelle l'un des signaux A et B est amené à l'état haut. Cela correspond par exemple un état d'attente dans lequel la porte C est entrée. Ainsi, au moins l'un des transistors 114, 116, et au moins l'un des transistors 118, 120, va être conducteur. Dans l'exemple de la figure 3, le signal A est amené à l'état haut. Ensuite, pendant la période 308, le signal d'écriture WR est activé, ce qui par exemple provoque le passage d'un courant positif dans l'élément résistif 202 et le passage d'un courant négatif dans l'élément résistif 204. En particulier, en référence à la figure 2, une ligne en trait alterné illustre un exemple du chemin de ce courant d'écriture, qui passe du rail d'alimentation VDD, par les transistors 116 et 226, par l'élément résistif 202, par le transistor 210, par l'élément résistif 204 et par les transistors 218 et 222, vers le rail de masse. Avantageusement, la génération du courant d'écriture fait ainsi usage des transistors existants de la porte C.

Le signal d'écriture WR passe ensuite de nouveau à l'état bas, et une période de coupure d'alimentation 310 a lieu pendant que la tension VDD sur le rail de tension d'alimentation est amené à l'état bas. Bien que la durée de cette période soit relativement courte dans l'exemple de la figure 2, elle peut être d'une durée quelconque. Le signal Az, qui est normalement haut, passe aussi par exemple à l'état bas pendant la période de coupure d'alimentation 310.

A la fin de la période de coupure d'alimentation 310, la tension VDD et le signal Az sont amenés de nouveau à l'état haut, et la porte C passe dans un état non prédictible, celui-ci étant dans l'exemple de la figure 3 l'état zéro. Les signaux A et B sont ensuite tous deux activés pour mettre l'état à l'état logique 1, bien que cette étape soit optionnelle, et serve ici seulement à illustrer qu'une restauration est possible quel que soit l'état initial de la porte C.

Dans une période suivante 312, une phase de restauration a lieu dans laquelle le signal Az est amené à l'état bas. Cela a pour effet d'amener la tension sur les noeuds de mémorisation à un niveau intermédiaire. En outre, le signal RD est amené à l'état haut pour rendre conducteurs les transistors 212 et 214, et générer des courants dans chacun des éléments résistifs 202, 204. Le niveau de courant dans chaque élément résistif 202, 204 va dépendre de sa résistance programmée. Ensuite, lorsque le signal Az est de nouveau amené à l'état haut, le courant déséquilibré dans chaque branche provoque le passage de la tension sur le noeud de mémorisation Z à une valeur basse. Le signal RD passe ensuite à l'état bas pour rendre les transistors 212 et 214 non conducteurs.

Pendant des périodes suivantes 316 à 326, les mêmes opérations ont lieu que pendant les périodes 304 à 312, excepté qu'un état logique 1 est programmé sur le noeud de mémorisation Z à la place de l'état zéro. On notera que dans la période 318, l'un des signaux A et B est amené à l'état bas pour assurer qu'au moins l'un des transistors 114, 116 et au moins l'un des transistors 118, 120 est conducteur. Comme cela est représenté par une flèche en trait mixte en figure 2, le courant d'écriture pendant la période 320 va s'écouler du rail d'alimentation VDD, par les transistors 217 et 216, par l'élément résistif 204, par le transistor 210, par l'élément résistif 202 et par les transistors 120 et 122, vers le rail de masse.

Les figures 4 et 5 illustrent les structures d'éléments à couple de transfert de spin (STT) selon des exemples de réalisation. Par exemple, chacun des éléments résistifs 202 et/ou 204 de la figure 2 a une structure correspondant à celle de la figure 4 ou de la figure 5. En variante, comme cela a été mentionné précédemment, les éléments résistifs pourraient être des éléments de RAM redOx, des éléments de FeRAM, des éléments de PCRAM, ou d'autres types d'éléments résistifs ayant une résistance programmable par le sens d'un courant.

La figure 4 illustre un élément résistif STT 400 ayant une anisotropie magnétique dans le plan. L'élément 400 est par exemple sensiblement cylindrique, mais a une section qui est non circulaire, par exemple ovale, ce qui conduit par exemple à une augmentation de la stabilité de rétention des états résistifs lorsque le dispositif est programmé.

L'élément 400 comprend des électrodes inférieure et supérieure 402 et 404, chacune ayant sensiblement une forme de disque, et prenant en sandwich entre elles un certain nombre de couches intermédiaires. Les couches intermédiaires comprennent, du bas vers le haut, une couche fixe 406, une barrière d'oxydation 408, et une couche de mémorisation 410.

La barrière d'oxydation 408 est par exemple constituée de MgO ou de AlₓO_{y}. La couche fixe 406 et la couche de mémorisation 410 sont par exemple en matériau ferromagnétique, comme du CoFe. La direction de spin de la couche fixe 406 est fixe, comme cela est représenté par une flèche allant de la gauche vers la droite en figure 4. Bien sûr, dans des variantes de réalisation, la direction de spin pourrait être de la droite vers la gauche dans la couche fixe 406. Cependant, la direction de spin dans la couche de mémorisation 410 peut être changée, comme cela est représenté par des flèches dans des directions opposées en figure 4. La direction de spin est programmée par la direction du courant d'écriture I qu'on fait passer dans l'élément, de sorte que la direction de spin dans la couche de mémorisation est parallèle, en d'autres termes dans la même direction, ou antiparallèle, en d'autres termes dans la direction opposée, à celle de la couche fixe 406.

La figure 5 illustre un élément résistif STT 500 ayant une anisotropie magnétique perpendiculaire au plan. Un tel élément résistif peut par exemple être programmé par un courant d'écriture I inférieur à celui de l'élément 400 pour une taille donnée et/ou pour un volume de couche de mémorisation donnée.

L'élément 500 est sensiblement cylindrique, et a par exemple une section qui est circulaire. L'élément 500 comprend des électrodes inférieure et supérieure, 502 et 504, chacune ayant sensiblement une forme de disque et prenant en sandwich un certain nombre de couches intermédiaires. Les couches intermédiaires comprennent, du bas vers le haut, une couche fixe 506, une barrière d'oxydation 508, et une couche de mémorisation 510. Ces couches sont similaires aux couches correspondantes, 406, 408 et 410 de l'élément 400, excepté que la couche fixe 506 et la couche de mémorisation 510 ont une anisotropie perpendiculaire au plan, comme cela est représenté par les flèches verticales dans les couches 506 et 510 de la figure 5. La couche fixe 506 est illustrée comme ayant une direction de spin allant du bas vers le haut en figure 5, mais bien sûr, dans des variantes de réalisation, cette direction de spin pourrait être du haut vers le bas.

Si l'élément STT 400 ou 500 de la figure 4 ou 5 est utilisé pour mettre en oeuvre chacun des éléments résistifs 202, 204 décrits ici, leurs orientations peuvent par exemple être choisies pour minimiser le niveau de courant d'écriture qui permet de les programmer. En particulier, en fonction de facteurs comme les dimensions des éléments 202, 204, un courant d'écriture faible pourrait être possible lorsque chaque élément a son électrode inférieure 402, 502 connectée au noeud de mémorisation correspondant ***Q̅*,** Z, ou l'inverse peut être vrai.

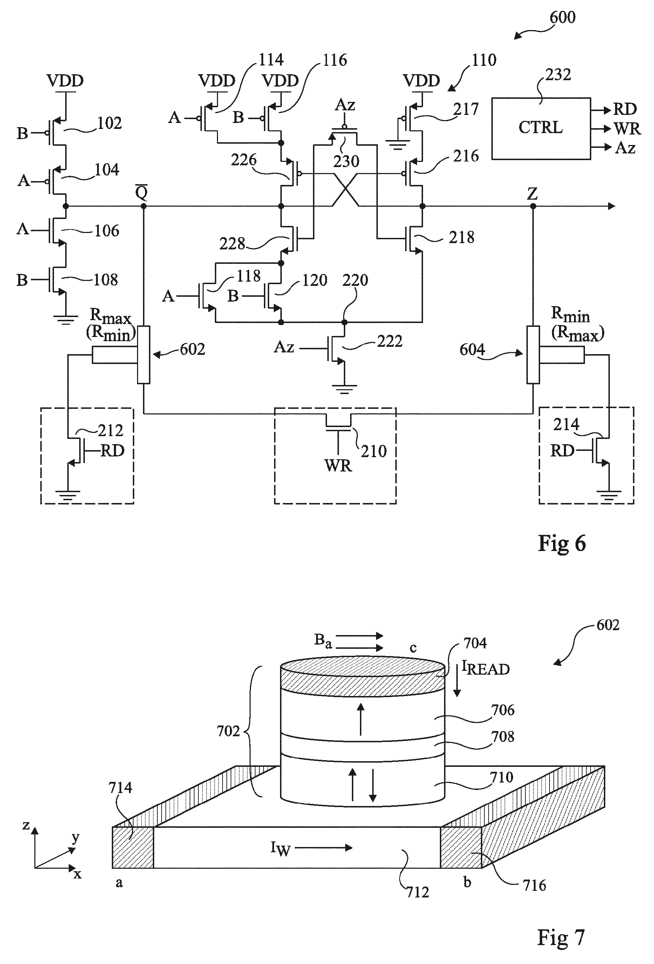

La figure 6 illustre schématiquement un circuit 600 selon une variante de réalisation très similaire au circuit de la figure 2, et de mêmes éléments portent des références identiques et ne seront pas décrits de nouveau en détail. Cependant, dans le mode de réalisation de la figure 6, les éléments résistifs 202, 204 ont été remplacés par des éléments résistifs 602, 604 respectivement, chacun d'eux étant un dispositif à trois bornes, comme on va le décrire maintenant en référence dans la figure 7.

La figure 7 illustre, dans une vue en perspective, l'élément résistif 602 de la figure 6 plus en détail selon un exemple de réalisation. L'élément résistif 604 a par exemple une structure similaire.

L'élément résistif 602 est par exemple une jonction tunnel magnétique à couple spin-orbite (SOT-MTJ). Un tel dispositif est par exemple décrit plus en détail dans la publication intitulée "Voltage and Energy-Delay Performance of Giant Spin Hall Effect Switching for Magnetic Memory and Logic", S. Manipatruni et al., et dans la publication intitulée "Spin-Torque Switching with the Giant Spin Hall Effect of Tantalum", Luqiao Liu et al., DOI: 10.1126/science.1218197 Science 336, 555 (2012), dont le contenu fait partie de la présente description dans les limites autorisées par la loi.

L'élément à mémoire résistive 602 comprend trois bornes de connexion, référencées a, b et c en figure 7. La borne c fait partie d'un empilement résistif 702 qui comprend une électrode 704 formée sur une couche nano-magnétique de référence 706. La couche 706 est elle-même constituée d'une couche isolante 708, et la couche 708 est elle-même formée sur une couche non magnétique de mémorisation 710.

La couche de référence 706 correspond à une couche magnétique dans laquelle la direction d'aimantation est fixe. La couche de mémorisation 710 au contraire correspond à une couche magnétique dans laquelle la direction d'aimantation peut être contrôlée.

L'empilement résistif 702 est formé sur une couche conductrice 712 qui assure l'interface pour programmer la direction d'aimantation de la couche de mémorisation 710. La couche conductrice 712 est par exemple constituée de : tantale β (β-Ta) ; tungstène β (β-W); et/ou de platine (Pt), et comprend par exemple, au niveau d'extrémités opposées, une électrode 714 formant une borne a de l'élément 700 et une électrode 716 formant une borne b de l'élément 700. Chacune des électrodes 714, 716 est par exemple constituée de cuivre, ou d'un autre matériau approprié.

Comme cela est représenté par des flèches Bₐ en figure 7, un champ magnétique statique, fourni par exemple par un aimant permanent ou une couche de polarisation, est par exemple présent à proximité de la couche de référence 706. Un tel champs magnétique est par exemple décrit plus en détail dans la publication intitulée "Perpendicular switching of a single ferromagnetic layer induced by in-plane current injection" Ioan mihai Miron et al., Nature 476, 189-193, DOI: 10.1038/nature10309.11, August 2011, dont le contenu fait partie de la présente description dans les limites autorisées par la loi.

Pendant une opération d'écriture, un courant est appliqué à partir de la borne a vers la borne b, ou dans la direction opposée, afin de programmer la direction d'aimantation dans la couche de mémorisation 710. Comme cela est représenté par des flèches x, y, et z en figure 7, la direction du courant d'écriture I_{W} passant dans la couche conductrice 712 à partir de la borne a vers la borne b sera appelée direction +x, la direction perpendiculaire à la direction +x dans le plan de la couche conductrice sera appelée direction +y, et la direction vers le haut perpendiculaire aux directions +x et +y sera appelée direction +z. Un courant d'écriture positif I_{W} dans la direction +x va produire un courant d'injection de spin avec une direction de transport dans la direction +z, et des spins pointant dans la direction +y. Le courant de spin injecté dans la direction +z va à son tour produire un couple de spin pour aligner l'aimantation dans la direction +y. Un courant d'écriture négatif I_{W} dans la direction -x va produire un courant d'injection de spin avec une direction de transport dans la direction -z, et des spins pointant dans la direction -y. Le courant de spin injecté dans la direction -z va à son tour produire un couple de spin pour aligner l'aimantation dans la direction -y.

Lorsque la direction d'aimantation dans la couche de mémorisation 710 est la même que celle de la couche de référence 706, la résistance de l'empilement résistif 702 est par exemple à une valeur relativement faible Rₘᵢₙ. Lorsque la direction de l'aimantation dans la couche de mémorisation 710 est opposée à celle de la couche de référence 706, la résistance de l'empilement résistif 702 est par exemple à une valeur relativement haute Rₘₐₓ.

Il apparaîtra clairement à l'homme de l'art que la structure représentée en figure 7 n'est qu'un exemple de structure possible d'un élément résistif programmable à trois bornes. Dans des variantes de réalisation, une ou plusieurs couches additionnelles pourraient être incluses, et différentes combinaisons de matériaux pourraient être utilisées. En outre, il apparaîtra clairement à l'homme de l'art qu'un noeud de lecture additionnel pourrait être prévu, par exemple sur le dessous de la couche conductrice 712, ou ailleurs, de sorte que les électrodes 714 et 716 seraient utilisées exclusivement pour l'écriture.

Le fonctionnement du circuit de la figure 6 est très similaire à celui de la figure 2, et ne sera pas décrit en détail.

Un avantage des modes de réalisation décrits ici est que, en réalisant une phase de sauvegarde pendant une phase d'attente de la porte C pendant laquelle les signaux A et B ont des niveaux logiques différents, les transistors déjà présents dans la porte C peuvent être utilisés pour faire passer le courant d'écriture destiné à programmer les états résistifs des éléments résistifs.

Avec la description ainsi faite d'au moins un mode de réalisation illustratif, diverses altérations, modifications et améliorations apparaîtront facilement à l'homme de l'art.

Par exemple, il apparaîtra clairement à l'homme de l'art que la tension d'alimentation VDD dans les divers modes de réalisation pourrait avoir un niveau quelconque, par exemple, compris entre 1 et 3 V, et plutôt que d'être à 0 V, la tension de masse pourrait aussi être considérée comme une tension d'alimentation qui pourrait avoir un niveau quelconque, comme un niveau négatif.

En outre, il apparaîtra clairement à l'homme de l'art que, dans tous les modes de réalisation décrits ici, tous les transistors NMOS pourraient être remplacés par des transistors PMOS et/ou tous les transistors PMOS pourraient être remplacés par des transistors NMOS. La façon dont les circuits pourraient être mis en oeuvre en utilisant seulement des transistors PMOS ou seulement des transistors NMOS apparaîtra clairement à l'homme de l'art, par exemple en inversant les rails d'alimentation. En outre, bien qu'on ait décrit ici des transistors basés sur la technologie MOS, dans des variantes de réalisation on pourrait utiliser d'autres technologies de transistors, comme la technologie bipolaire.

En outre, il apparaîtra clairement à l'homme de l'art que les divers éléments décrits en relation avec les divers modes de réalisation pourraient être combinés dans des variantes de réalisation, selon des combinaisons quelconques.

## Revendications

1. Circuit comprenant :
une porte C comportant des premier et deuxième noeuds d'entrée et des premier et deuxième inverseurs (110, 112) couplés de façon croisée entre des premier et deuxième noeuds de mémorisation complémentaires (***Q̅*,** Z), le deuxième noeud de mémorisation (Z) formant un noeud de sortie de la porte C ; et
une mémoire non volatile **caractérisée par** :
un premier élément résistif (202, 602) ayant une première borne couplée au premier noeud de mémorisation (***Q̅***);
un deuxième élément résistif (204, 604) ayant une première borne couplée au deuxième noeud de mémorisation (Z), au moins l'un des premier et deuxième éléments résistifs étant programmable pour prendre l'un d'au moins deux états résistifs (R_{min'} Rₘₐₓ), une valeur de données étant représentée par les résistances relatives des premier et deuxième éléments résistifs, une deuxième borne du premier élément résistif (202, 602) étant couplée à une deuxième borne du deuxième élément résistif (204, 604) par l'intermédiaire d'un premier transistor (210) ; et
un circuit de commande (232) adapté, pendant une phase de sauvegarde vers la mémoire non volatile d'un bit de données mémorisé au niveau des premier et deuxième noeuds de mémorisation, à rendre conducteur le premier transistor (210) pendant que des niveaux logiques différents sont appliqués aux premier et deuxième noeuds d'entrée de la porte C.

2. Circuit selon la revendication 1, dans lequel le premier transistor (210) est adapté à conduire un courant d'écriture pendant la phase de sauvegarde, et dans lequel le circuit est agencé de telle sorte que le courant d'écriture passe à travers au moins un transistor de chacun des premier et deuxième inverseurs (110, 112) pendant la phase d'écriture.

3. Circuit selon la revendication 1 ou 2, dans lequel :
la porte C est adaptée à recevoir un premier signal d'entrée (A) sur le premier noeud d'entrée et un deuxième signal d'entrée (B) sur le deuxième noeud d'entrée ; et
le premier inverseur (112) comprend : des premier et deuxième transistors (226, 228) ayant leurs noeuds de commande couplés au premier ou au deuxième noeud de mémorisation (***Q̅***, Z) ; des troisième et quatrième transistors (114, 116) couplés en parallèle entre eux et couplant le premier transistor du premier inverseur à un rail de tension d'alimentation (VDD) ; et des cinquième et sixième transistors (118, 120) couplés en parallèle entre eux et couplant le deuxième transistor du premier inverseur au rail de tension de masse.

4. Circuit selon la revendication 3, dans lequel le deuxième inverseur (110) comprend : des premier et deuxième transistors (216, 218) ayant leurs noeuds de commande couplés au deuxième ou au premier noeud de mémorisation ; et un troisième transistor (217) couplant le premier transistor du deuxième inverseur au rail de tension d'alimentation et ayant son noeud de commande couplé au rail de tension de masse.

5. Circuit selon la revendication 4, dans lequel les cinquième et sixième transistors du premier inverseur (112) et le deuxième transistor du deuxième inverseur sont couplés à un noeud commun (220), le circuit comprenant en outre un septième transistor (222) couplé entre le noeud commun et le rail de tension de masse.

6. Circuit selon l'une quelconque des revendications 1 à 5, comprenant en outre un huitième transistor (212) couplé entre le premier élément résistif (202, 602) et le rail de tension de masse et un neuvième transistor (214) couplé entre le deuxième élément résistif (204, 604) et le rail de tension de masse, le circuit de commande (232) étant en outre adapté à rendre conducteurs les huitième et neuvième transistors (212, 214) pendant une phase de restauration du bit de données mémorisé par les éléments résistifs vers les noeuds de mémorisation (***Q̅***, Z).

7. Circuit selon la revendication 6, dans lequel le huitième transistor (212) est couplé à la deuxième borne du premier élément résistif (202), et le neuvième transistor (214) est couplé à la deuxième borne du deuxième élément résistif (204).

8. Circuit selon l'une quelconque des revendications 1 à 7, dans lequel au moins l'un des premier et deuxième éléments résistifs (202, 204) est de l'un des types suivants :
un élément à couple de transfert de spin ayant une anisotropie dans le plan ;
un élément à couple de transfert de spin ayant une anisotropie perpendiculaire au plan ;
un élément à oxydoréduction (RedOx) ;
un élément ferroélectrique ; et
un élément à changement de phase.

9. Circuit selon la revendication 6, dans lequel les premier et deuxième éléments résistifs (602 604) comprennent chacun une troisième borne, et dans lequel le huitième transistor (212) est couplé à la troisième borne du premier élément résistif (602), et le neuvième transistor (214) est couplé à la troisième borne du deuxième élément résistif (604).

10. Circuit selon la revendication 9, dans lequel l'élément résistif est du type à jonction tunnel magnétique à couple spin-orbite (SOT-MTJ).

11. Circuit intégré comprenant une pluralité de blocs asynchrones comprenant chacun le circuit de l'une quelconque des revendications 1 à 10.

12. Procédé de sauvegarde de données dans un circuit comprenant : une porte C comportant des premier et deuxième noeuds d'entrée et des premier et deuxième inverseurs (110, 112) couplés de façon croisée entre des premier et deuxième noeuds de mémorisation complémentaires (***Q̅***, Z), le deuxième noeud de mémorisation (Z) formant un noeud de sortie de la porte C ; et une mémoire non volatile **caractérisée par** : un premier élément résistif (202, 602) ayant une première borne couplée au premier noeud de mémorisation (***Q̅***); un deuxième élément résistif (204, 604) ayant une première borne couplée au deuxième noeud de mémorisation (Z), au moins l'un des premier et deuxième éléments résistifs étant programmable pour prendre l'un d'au moins deux états résistifs (R_{min'} Rₘₐₓ), une valeur de données étant représentée par les résistances relatives des premier et deuxième éléments, une deuxième borne du premier élément résistif étant couplée à une deuxième borne du deuxième élément résistif par l'intermédiaire d'un premier transistor (210), le procédé comprenant :
rendre conducteur le premier transistor (210) pendant que des niveaux logiques différents sont appliqués aux premier et deuxième noeuds d'entrée de la porte C.

## Patentansprüche

1. Eine Schaltung, die Folgendes aufweist:
ein C-Element mit ersten und zweiten Eingangsknoten und ersten und zweiten Invertierern (110, 112), die zwischen ersten und zweiten komplementären Speicherknoten (*Q̅*, Z) kreuzgekoppelt sind, wobei der zweite Speicherknoten (Z) einen Ausgangsknoten des C-Elementes bildet; und
einen nicht flüchtigen Speicher, der **gekennzeichnet ist durch**:
ein erstes Widerstandselement bzw. resistives Element (202, 602) mit einem ersten Anschluss, der an den ersten Speicherknoten (*Q̅*) gekoppelt ist;
ein zweites resistives Element (204, 604) mit einem ersten Anschluss, der an den zweiten Speicherknoten (Z) gekoppelt ist, wobei wenigstens eines der ersten und zweiten resistiven Elemente programmierbar ist, um einen von wenigstens zwei resistiven Zuständen (Rₘᵢₙ, Rₘₐₓ) zu haben, wobei ein Datenwert **durch** die relativen Widerstände der ersten und zweiten resistiven Elemente dargestellt wird, wobei ein zweiter Anschluss des ersten resistiven Elements (202, 602) an einen zweiten Anschluss des zweiten resistiven Elements (204, 604) über einen ersten Transistor (210) gekoppelt ist; und
eine Steuerschaltung (232), die ausgelegt ist, während einer Backup-Phase eines Datenbits, das in den ersten und zweiten Speicherknoten gespeichert ist, auf den nicht flüchtigen Speicher, den ersten Transistor (210) leitend zu machen, während unterschiedliche Logikpegel auf die ersten und zweiten Eingangsknoten des C-Elementes angewandt werden.

2. Schaltung nach Anspruch 1, wobei der erste Transistor (210) ausgelegt ist,zum Leiten eines Schreibstroms während der Backup-Phase, und wobei die Schaltung angeordnet ist, so dass der Schreibstrom durch wenigstens einen Transistor jedes der ersten und zweiten Invertierer (110, 112) während der Schreibphase hindurchläuft.

3. Schaltung nach Anspruch 1 oder 2, wobei:
das C-Element ausgelegt ist zum Empfangen eines ersten Eingangssignals (A) an dem ersten Eingangsknoten und eines zweiten Eingangssignals (B) an dem zweiten Eingangsknoten; und
der erste Invertierer (112) Folgendes aufweist: erste und zweite Transistoren (226, 228), deren Steuerknoten an die ersten und zweiten Speicherknoten (*Q̅*, Z) gekoppelt sind; dritte und vierte Transistoren (114, 116), die parallel zueinander gekoppelt sind und die den ersten Transistor des ersten Invertierers an eine Versorgungsspannungsschiene (VDD) koppeln; und fünfte und sechste Transistoren (118, 120), die parallel zueinander gekoppelt sind und den zweiten Transistor des ersten Invertierers an die Massespannungsschiene koppeln.

4. Schaltung nach Anspruch 3, wobei der zweite Invertierer (110) Folgendes aufweist: erste und zweite Transistoren (216, 218), deren Steuerknoten an den zweiten oder ersten Speicherknoten gekoppelt sind; und einen dritten Transistor (217), der den ersten Transistor des zweiten Invertierers an die Versorgungsspannungsschiene koppelt und dessen Steuerknoten an die Massespannungsschiene gekoppelt ist.

5. Schaltung nach Anspruch 4, wobei die fünften und sechsten Transistoren des ersten Invertieres (112) und der zweite Transistor des zweiten Invertierers an einen gemeinsamen Knoten (220) gekoppelt sind, wobei die Schaltung weiter einen siebten Transistor (222) aufweist, der zwischen den gemeinsamen Knoten und die Massespannungsschiene gekoppelt ist.

6. Schaltung nach einem der Ansprüche 1 bis 5, die weiter einen achten Transistor (212), der zwischen das erste resistive Element (202, 602) und die Massespannungsschiene gekoppelt ist, und einen neunten Transistor (214), der zwischen das zweite resistive Element (204, 604) und die Massespannungsschiene gekoppelt ist, aufweist, wobei die Steuerschaltung (232) weiter ausgelegt ist, die achten und neunten Transistoren (212, 214) leitend zu machen, und zwar während einer Wiederherstellungsphase des Datenbits, das durch die resistiven Elemente gespeichert ist, auf die Speicherknoten (*Q̅*, Z).

7. Schaltung nach Anspruch 6, wobei der achte Transistor (212) an den zweiten Anschluss des ersten resistiven Elements (202) gekoppelt ist, und der neunte Transistor (214) an den zweiten Anschluss des zweiten resistiven Elements (204) gekoppelt ist.

8. Schaltung nach einem der Ansprüche 1 bis 7, wobei wenigstens eines der ersten und zweiten resistiven Elemente (202, 204) eines von Folgendem ist:
ein Spin-Transfer-Torque-Element mit einer Anisotropie innerhalb einer Ebene;
ein Spin-Transfer-Torque-Element mit einer Anisotropie senkrecht zu einer Ebene;
eine Reduktionsoxid- bzw. RedOx-Element;
ein ferroelektrisches Element; und
einen Phasenveränderungselement.

9. Schaltung nach Anspruch 6, wobei die ersten und zweiten resistiven Elemente (602, 604) jeweils einen dritten Anschluss aufweisen, und wobei der achte Transistor (212) an den dritten Anschluss des ersten resistiven Elementes (602) gekoppelt ist, und der neunte Transistor (214) an den dritten Anschluss des zweiten resistiven Elements (604) gekoppelt ist.

10. Schaltung nach Anspruch 9, wobei das Widerstandselement bzw. resistive Element vom SOT-Magnettunnelkontakt- bzw. SOT-MTJ-Typ (SOT-MTJ = spin orbit torque magnetic tunnel junction) ist.

11. Eine integrierte Schaltung, die eine Vielzahl asynchroner Blöcke aufweist, von denen jeder die Schaltung nach einem der Ansprüche 1 bis 10 aufweist.

12. Ein Verfahren zum Daten-Backup in einer Schaltung, die Folgendes aufweist: ein C-Element mit ersten und zweiten Eingangsknoten und ersten und zweiten Invertierern (110, 112), die zwischen ersten und zweiten komplementären Speicherknoten (*Q̅*, Z) kreuzgekoppelt sind, wobei der zweite Speicherknoten (Z) einen Ausgangsknoten des C-Elementes bildet; und einen nicht flüchtigen Speicher, der **gekennzeichnet ist durch**: ein erstes resistives Element (202, 602) mit einem ersten Anschluss, der an den ersten Speicherknoten (*Q̅*) gekoppelt ist; ein zweites resistives Element (204, 604) mit einem ersten Anschluss, der an den zweiten Speicherknoten (Z) gekoppelt ist, wobei wenigstens eines der ersten und zweiten resistiven Elemente programmierbar ist, um einen von wenigstens zwei resistiven Zuständen (Rₘᵢₙ, Rₘₐₓ) zu haben, wobei ein Datenwert **durch** die relativen Widerstände der ersten und zweiten resistiven Elemente dargestellt wird, wobei ein zweiter Anschluss des ersten resistiven Elements an einen zweiten Anschluss des zweiten resistiven Elements über einen ersten Transistor (210) gekoppelt ist; und wobei das Verfahren Folgendes aufweist: Leitend-Machen des ersten Transistors (210) während verschiedene Logikpegel an die ersten und zweiten Eingangsknoten des C-Elementes angelegt werden.

## Claims

1. A circuit comprising:
a C-element having first and second input nodes and first and second inverters (110, 112) cross-coupled between first and second complementary storage nodes (*Q̅*, Z), the second storage node (Z) forming an output node of the C-element; and
a non-volatile memory **characterized by**:
a first resistive element (202, 602) having a first terminal coupled to the first storage node (*Q̅*);
a second resistive element (204, 604) having a first terminal coupled to the second storage node (Z), at least one of the first and second resistive elements being programmable to have one of at least two resistive states (Rₘᵢₙ, Rₘₐₓ), a data value being represented by the relative resistances of the first and second resistive elements, wherein a second terminal of the first resistive element (202, 602) is coupled to a second terminal of the second resistive element (204, 604) via a first transistor (210); and
a control circuit (232) adapted, during a backup phase of a data bit stored at the first and second storage nodes to the non-volatile memory, to render conductive the first transistor (210) while different logic levels are applied to the first and second input nodes of the C-element.

2. The circuit of claim 1, wherein the first transistor (210) is adapted to conduct a write current during the backup phase, and wherein the circuit is arranged such that the write current passes through at least one transistor of each of the first and second inverters (110, 112) during the write phase.

3. The circuit of claim 1 or 2, wherein:
the C-element is adapted to receive a first input signal (A) at the first input node and a second input signal (B) at the second input node; and
the first inverter (112) comprises: first and second transistors (226, 228) having their control nodes coupled to the first or second storage node (*Q̅*, Z); third and fourth transistors (114, 116) coupled in parallel with each other and coupling the first transistor of the first inverter to a supply voltage rail (VDD); and fifth and sixth transistors (118, 120) coupled in parallel with each other and coupling the second transistor of the first inverter to the ground voltage rail.

4. The circuit of claim 3, wherein the second inverter (110) comprises: first and second transistors (216, 218) having their control nodes coupled to the second or first storage node; and a third transistor (217) coupling the first transistor of the second inverter to the supply voltage rail and having its control node coupled to the ground voltage rail.

5. The circuit of claim 4, wherein the fifth and sixth transistors of the first inverter (112) and the second transistor of the second inverter are coupled to a common node (220), the circuit further comprising a seventh transistor (222) coupled between the common node and the ground voltage rail.

6. The circuit of any of claims 1 to 5, further comprising an eighth transistor (212) coupled between the first resistive element (202, 602) and the ground voltage rail and a ninth transistor (214) coupled between the second resistive element (204, 604) and the ground voltage rail, wherein the control circuit (232) is further adapted to render conductive the eighth and ninth transistors (212, 214) during a restore phase of the data bit stored by the resistive elements to the storage nodes (*Q̅*, Z).

7. The circuit of claim 6, wherein the eighth transistor (212) is coupled to the second terminal of the first resistive element (202), and the ninth transistor (214) is coupled to the second terminal of the second resistive element (204).

8. The circuit of any of claims 1 to 7, wherein at least one of said first and second resistive elements (202, 204) is one of:
a spin transfer torque element with in-plane anisotropy;
a spin transfer torque element with perpendicular-to-plane anisotropy;
a reduction oxide (RedOx) element;
a ferro-electric element; and
a phase change element.

9. The circuit of claim 6, wherein the first and second resistive elements (602, 604) each comprise a third terminal, and wherein the eighth transistor (212) is coupled to the third terminal of the first resistive element (602), and the ninth transistor (214) is coupled to the third terminal of the second resistive element (604).

10. The circuit of claim 9, wherein said resistive element is of the spin orbit torque magnetic tunnel junction (SOT-MTJ) type.

11. An integrated circuit comprising a plurality of asynchronous blocks each comprising the circuit of any of claims 1 to 10.

12. A method of data backup in a circuit comprising: a C-element having first and second input nodes and first and second inverters (110, 112) cross-coupled between first and second complementary storage nodes (*Q̅*, Z), the second storage node (Z) forming an output node of the C-element; and a non-volatile memory **characterized by**: a first resistive element (202, 602) having a first terminal coupled to the first storage node (*Q̅*) ; a second resistive element (204, 604) having a first terminal coupled to the second storage node (Z), at least one of the first and second resistive elements being programmable to have one of at least two resistive states (Rₘᵢₙ, Rₘₐₓ), a data value being represented by the relative resistances of the first and second resistive elements, wherein a second terminal of the first resistive element is coupled to a second terminal of the second resistive element via a first transistor (210), the method comprising:
rendering conductive the first transistor (210) while different logic levels are applied to the first and second input nodes of the C-element.
